# EUROPEAN PATENT SPECIFICATION

(11) **EP 1 718 102 B1**
(45) Date of publication and mention of the grant of the patent: **24.03.2021**
(21) Application number: 05252567.2
(22) Date of filing: 25.04.2005
(51) Int. Cl.: H03F 1/30, H03F 3/181, H03F 3/68, H04R 1/02, H03F 3/45

(54) **Speaker system having improved RF immunity to RF electromagnetic interferences produced from mobile wireless communications device**
Lautsprechersystem mit erhöhter Störfestigkeit gegen von drahtlosen Kommunikationsgeräten ausgestrahlte elektromagnetische Störungen
Système de haut-parleurs à immunité RF améliorée contre les interférences électromagnétiques RF produites par des appareils de communication mobile sans fil

(43) Date of publication of application: 02.11.2006
(73) Proprietor: BlackBerry Limited, Waterloo, ON N2K 0A7 (CA)
(72) Inventor: Zhu, Lizhong, Waterloo, Ontario N2T 2T8 (CA); Mankaruse, George, Kitchener, Ontario N2H 5G1 (CA); Corrigan, Michael, Waterloo, Ontario N2T 1S5 (CA)
(74) Representative: Hanna Moore + Curley

(56) References cited:
- US-A- 4 597 100
- US-A- 4 933 981
- UNKNOWN: "Class-T Digital Audio Amplifier Evaluation Board using Digital Power Processing TM Technology"[Online] April 2002 (2002-04), XP002353445 Retrieved from the Internet: URL:http://www.tripath.com/downloads/EB-TA 1101B.pdf> [retrieved on 2005-11-08]
- UNKNOWN: "AD82550 - Stereo Digital Audio Amplifier with Headphone Driver, rev. 1.0"[Online] January 2005 (2005-01), pages 1-15, XP002353446 Retrieved from the Internet: URL:http://www.sacg.com.tw/sacweb/marcom/e paper/images/AD82550_Rev1_0_01132005.pdf> [retrieved on 2005-11-08]
- ED FONG, SCOTT BOBO: "APPLICATION NOTE AN11: DESIGNING FOR EMI REGULATORY COMPLIANCE"[Online] 13 April 1999 (1999-04-13), XP002353447 Retrieved from the Internet: URL:http://www.tripath.com/downloads/an11. pdf> [retrieved on 2005-11-08]
- UNKNOWN: "Sony Active Speaker System SRS-A202 - Operating Instructions"[Online] 2003, XP002353448 Retrieved from the Internet: URL:http://www.amazon.com/gp/product/B0000 8Y1A7/102-0669977-3186507?v=glance&n=17228 2&v=glance> [retrieved on 2005-11-08]
- Benjamin Piazza: "Whitepaper - Shakti Innovations", , 1 January 2001 (2001-01-01), XP055666456, Retrieved from the Internet: URL:http://www.shakti-innovations.com/whit epaper.htm [retrieved on 2020-02-07]
- Dimitri Danyuk ET AL: "A RIAA Equalized Preamplifier", , 1 January 1992 (1992-01-01), XP055666457, Retrieved from the Internet: URL:http://www.angelfire.com/az3/dimitri/i mages/riaa.pdf [retrieved on 2020-02-07]
- Dan Banquer: "Eliminating RFI/EMI Interference from your Audio System | Audioholics", , 2 September 2004 (2004-09-02), XP055666461, Retrieved from the Internet: URL:https://www.audioholics.com/audio-vide o-cables/bulletproofing-your-system-from-i nterference [retrieved on 2020-02-07]
- Anonymous: "Turando USB Speakers (no sound card required)", , 26 January 2001 (2001-01-26), XP055673743, Retrieved from the Internet: URL:https://web.archive.org/web/2001012613 2800/http://www.usbgear.net/item_142.html [retrieved on 2020-03-04]

## Description

### Field of the Invention

This invention relates to speaker systems, and more particularly, this invention relates to speaker systems used with personal computers and similar applications.

### Background of the Invention

The use of desktop personal computers and notebook computers has become ubiquitous. Almost every household has some type of personal computer, and typically many households own a desktop computer and at least one notebook or "laptop" computer. With the increase in Internet usage over the last decade and the downloading and uploading of data, music, MP3 files, and video files, multimedia computer applications have become commonplace. Not only are a video card, high-resolution display, and fast microprocessor required for multimedia applications, but a personal computer speaker system is mandatory. Many of these computer speaker systems include, at a minimum, left and right speakers to form a stereo sound effect. The speakers are typically positioned on the video display or at selected locations around the desktop area adjacent to the computer. Additionally, small multimedia speaker systems are available for use with notebook computers. Some notebook computers even include high quality embedded stereo speakers incorporated within the body of the notebook computer, for example, near the lower end of the screen or adjacent to the keyboard.

Over the last decade that personal computer systems have become ubiquitous, so have the use of mobile wireless communications devices, for example, cellular radios, personal digital assistants (PDA's) and other mobile wireless communications devices. Often, individuals use these handheld devices at the same time they use their personal computer system. Because of the close proximity of the mobile wireless communications device to a personal computer speaker system when a user is operating both, often the RF electromagnetic energy from the handheld device causes interference with the audio or other circuits, creating an audible "buzz" sound through the speakers. This can be distracting, especially in conferences when two or more people are in attendance. Additionally, even when only one user of a mobile wireless communications device and personal computer system is present, this audible "buzz" from the personal computer speaker often is annoying to the user. Active speaker systems for computer usage are known e.g. from the following documents:
"Sony Active Speaker System SRS-A202 - Operating Instructions", 2003, http://www.amazon.com/gp/product/B00008Y1A7/102-0669977-3186507? v=glance&n=172282&v=glance;
"Turando USB Speakers (no sound card required)", 26 January 2001, https://web.archive.org/ web/20010126132800/http://www.usbgear.net/item_142.html.

Aspects of RF shielding for audio amplifiers can be found e.g. in the following documents:
"Class-T Digital Audio Amplifier Evaluation Board using Digital Power Processing TM Technology", April 2002, http://www.tripath.com/downloads/EB-TA1101B.pdf;
"AD82550 - Stereo Digital Audio Amplifier with Headphone Driver, rev. 1.0", January 2005, pages 1-15, http://www.sacg.com.tw/sacweb/marcom/epaper/images/ AD82550_Rev1_0_01132005.pdf;

US 4 597 100 A (GRODINSKY ET AL) 24 June 1986 (1986-06-24).

### Summary of the Invention

The present invention provides a speaker system as detailed in claim 1. Also provided is a method according to claim 7. Advantageous features are provided in the dependent claims.

### Brief Description of the Drawings

Other objects, features and advantages of the present invention will become apparent from the detailed description of the invention which follows, when considered in light of the accompanying drawings in which:

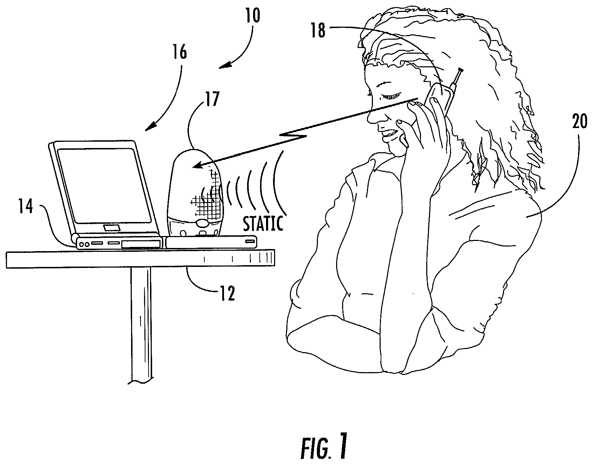

FIG. 1 is a fragmentary, environmental view of a personal computer workstation showing a desktop having a notebook computer situated thereon and a personal computer speaker system that is receiving RF energy from a mobile wireless communications device used by the user and creating interference and an audible "buzz" from the speaker system.

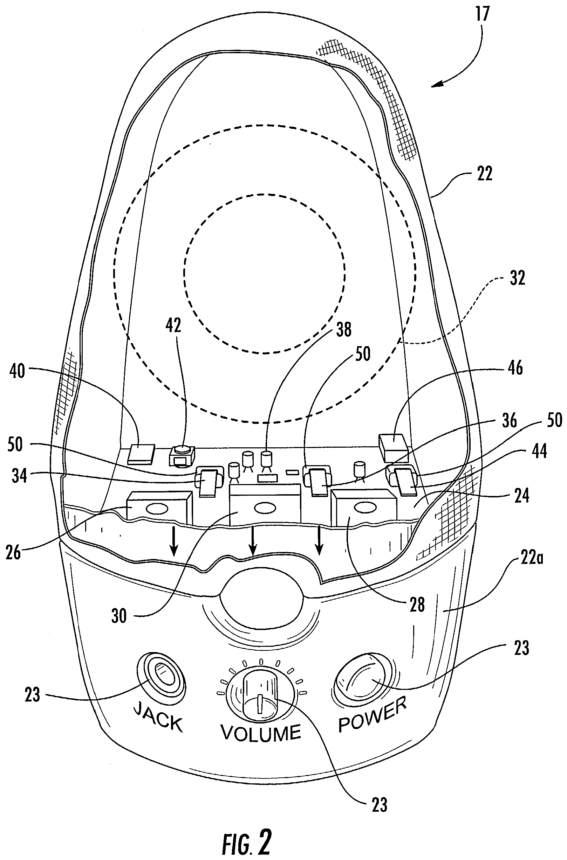

FIG. 2 is a fragmentary, partial front elevation view of a speaker system such as shown in FIG. 1 and having part of the front housing removed and showing a circuit board, including a RF shield surrounding various components to reduce the audio "buzz" created by RF electromagnetic interference received from a mobile wireless communications device operating in the vicinity of the speaker in accordance with the present invention.

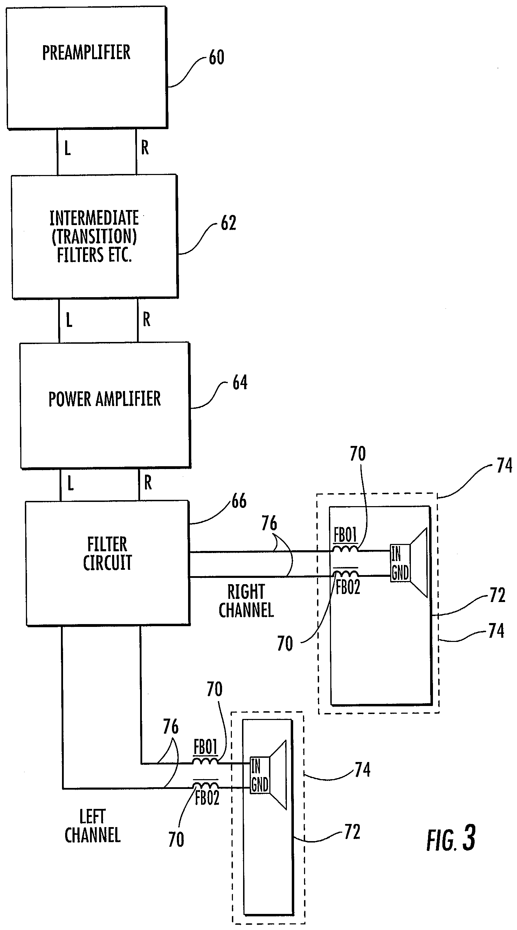

FIG. 3 is a block diagram of a personal computer speaker system showing basic functional components and RF filters operative with the speaker for reducing RF electromagnetic interference produced from a mobile wireless communications device not falling under the scope of the appended claims.

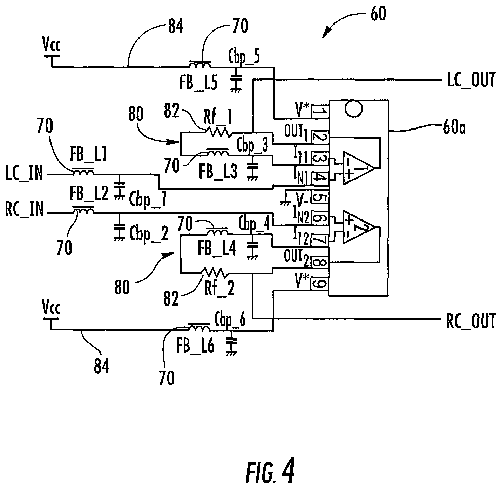

FIG. 4 is a schematic circuit diagram of an example of a preamplifier circuit that can be used in the speaker system shown in FIGS. 1-3 and showing the application of RF filters in accordance with the present invention.

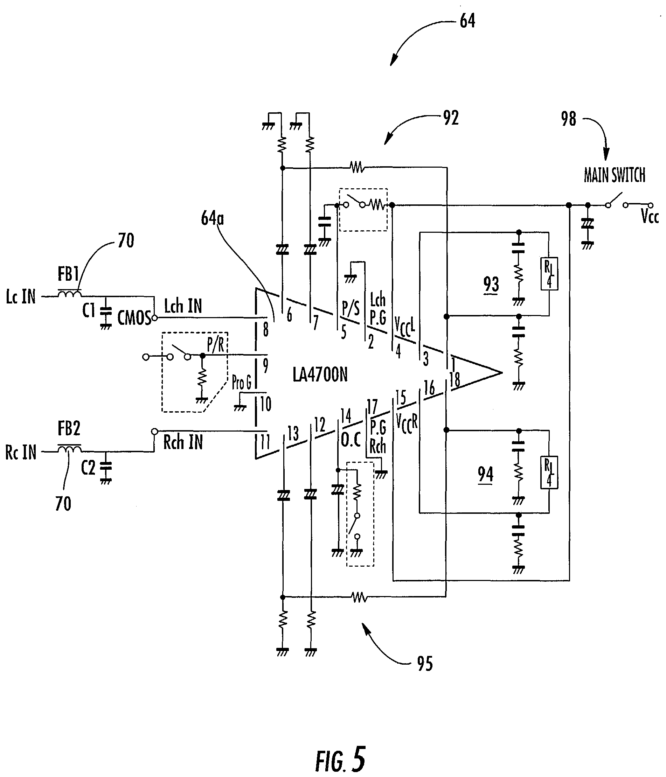

FIG. 5 is a schematic circuit diagram of an example of a power amplifier circuit that can be used in the personal computer speaker system such as shown in FIGS. 1-3 and showing the application of RF filters to reduce the audible "buzz" created by the RF electromagnetic interference from a mobile wireless communications device.

### Detailed Description of the Preferred Embodiments

The present invention will now be described more fully hereinafter with reference to the accompanying drawings, in which preferred embodiments of the invention are shown. This invention may, however, be embodied in many different forms and should not be construed as limited to the embodiments set forth herein. Like numbers refer to like elements throughout, and prime notation is used to indicate similar elements in alternative embodiments.

The present invention targets the audio "buzz" problem created by radio frequency (RF) electromagnetic interference from a mobile wireless communications device operating within close proximity to a speaker system such as used with a personal computer. To eliminate this audible "buzz", a number of RF filters can be applied to the audio amplifier circuitry, such as the preamplifier and power amplifier, and the audio transducer, such as the speaker. The RF filters could be formed as RF ferrite beads, serial inductors, or shunt capacitors to reduce the RF energy being picked-up by the transducers and/or other electronic components and coupled to non-linear circuits, which could rectify the RF energy. In another aspect of the invention, an RF shield could surround and isolate the transducer, for example the speaker, the power supply circuit, and any amplifier circuits. The added shielding can also provide grounding to sensitive areas, for example, an input to the audio preamplifier, power amplifier or power supply circuit to prevent RF pick-up and rectification.

FIG. 1 is a fragmentary, environmental view of a personal computer workstation **10** showing a desktop **12** with a personal computer, e.g. a notebook computer **14** situated thereon, and a personal computer speaker system **16** that includes a speaker **17** receiving RF energy from a mobile wireless communications device **18** used by the operator or user **20** of the personal computer **14.** The figure diagrammatically shows that an audible "buzz" is created by the use of the mobile wireless communications device **18** in close proximity to the personal computer speaker system **16.**

FIG. 2 is a fragmentary front elevation view of a speaker **17** such as shown in FIG. 1, and showing part of the front panel of the speaker housing **22** removed and showing electronic components positioned on the speaker circuit board **24.** The circuit board **24** is shown raised from its normal position, which is closer to the bottom of the speaker housing **22** adjacent the various hand controls **23** on the bottom section of the housing front panel **22a.** As shown, the speaker **17** includes the typical front-mounted hand controls **23** that are operative with components mounted on the circuit board, including an earphone plug jack **26,** a power plug **28** for turning the speaker ON and OFF, and a volume control **30** shown in the front center of the circuit board **24.** The audio transducer **32,** i.e. the receiver speaker in this case, would typically be mounted on the inside surface of the front panel **22a** of the housing **22.** Because that section is removed, the speaker **32** outline is shown in dashed lines.

The circuit board **24** includes the basic power supply circuit and audio circuits common to many speaker systems, especially used with personal computers. The audio circuitry in one nonlimiting example includes two integrated circuits formed as a preamplifier **34** and a power amplifier **36.** The power amplifier **36** and preamplifier **34** are connected by intermediate or transition circuitry **38** that includes various capacitors, resistors and other electronic components to form audio filters and other audio functions as known to those skilled in the art. Other components on the circuit board include a power plug **40** near the rear of the housing **22** that provides an input for an electrical supply, a transformer **42,** and a power supply circuit **44** which could be a power transistor, integrated circuit or other component. A speaker connection **46** is shown on the circuit board at the rear section of the housing **22,** for connecting to another external speaker. The front section of the circuit board **24** includes the respective electronic controls operative as the earphone plug jack **26,** power plug **28** and volume control **30** when the circuit board is lowered into its position as explained before.

In one aspect of the invention, the preamplifier **34** and power amplifier **36** are shielded by RF shields **50** as isolation shields or "cans", as often called by those skilled in the art, forming an isolation compartment on the circuit board for these components. The power supply circuitry **44** can also be shielded by an appropriate shield as formed as a "can". Typically, each RF shield **50** can be formed as a separate metallic housing secured to the circuit board **24** and surrounding the component, effectively covering, i.e., shielding the power supply circuits **44,** preamplifier **34** or power amplifier **36.** Although a "can" configuration formed as a metallic housing with top and sides can be used for the RF shield, other configurations could be used. Any compartment formed by the RF isolation shield receive the preamplifier **34,** power amplifier **36** or power supply circuit **44** as typically surface mounted integrated circuit chips on the circuit board. This RF isolation shield **50** typically has side and top metal walls forming a complete isolation field and provides the necessary isolation that will help in reducing the audible "buzz" in the speaker system.

FIG. 3 is a block diagram of the personal computer speaker system **16** showing basic components and the use of an RF shield operative with the audio transducer, such as the receiver speaker, to reduce the RF electromagnetic interference to the audio transducer and aid in minimizing the "buzz". Additionally, besides the use of an RF shield, RF filters can be operative with the audio transducer, i.e., the speaker for reducing RF electromagnetic interference to the speaker.

The speaker system **16** includes basic functional components of a preamplifier circuit **60,** intermediate or transition circuit **62,** power amplifier circuit **64** and a filter circuit **66.** The intermediate transition circuit **62** can include any filtering, buffering functions and electronic functions that may typically be interposed between a preamplifier circuit and power amplifier circuit used in speaker systems such as for personal computer system. For purposes of illustration, a left channel and right channel are shown operative with two different transducers or speakers in order to illustrate two different examples that have applied RF filters. As illustrated, a RF filter **70** is mounted at the speaker as a ferrite bead, serial inductor or shunt capacitor, connecting the two signal lines of the speaker. In the illustrated example, each filter **70** is serially connected into the speaker line, either inside the speaker housing **72** or outside the housing. Each filter is given the designation FB01 or FB02. The filter **70** can be serially connected between the audio circuitry, i.e., power amplifier circuit **64** and filter circuit **66,** and an electrical contact or a connection part of the speaker as shown at the lower section of FIG. 3. In another example, the speaker could include filters **70** contained within a speaker housing **72** as shown in the right-hand portion of FIG. 3. The dashed line around the speaker indicates a speaker RF shield **74** that could be provided around the speaker when it is mounted on the front section of the housing **22.** In one aspect of the present invention, to provide the speaker with RF isolation, the speaker RF isolation shield **74** forms an isolation "can" around the speaker and can be formed as a separate metallic housing secured to the front inside surface of the front section of the speaker housing **22** to shield much of the speaker from RF interfering energy generated by a mobile wireless communication device.

The RF filter **70** could be formed as ferrite beads, shunt capacitors, or serial inductors and placed within the speaker housing **72** or outside the speaker housing and connected into the audio connection lines **76** going back to the filter circuit **66** and power amplifier circuit **64** depending on how the speaker is manufactured. Typically, the RF filter would be placed very close to the speaker itself, limiting any line distance from the RF filter to the speaker. It should be understood that the term "speaker" could be synonymous with any type of audio transducer assembly that is carried by the speaker system to produce audible noises, including buzzers. The speaker could also be mounted on the circuit board instead of the housing in some embodiments, for example, by using a surface mounted speaker assembly. The circuit board **24,** of course, would have to be close to a speaker or side surface. The RF filter **70** could be formed as two filter components FB01, FB02 added serially into a speaker line and positioned within a speaker housing. In one example, the RF filter could be formed as a ferrite bead or as a surface mounted RF filter device positioned adjacent the electrical contacts and engaging any circuit board signal traces forming audio connection lines between the different speaker components.

Different types, sizes and shapes of ferrite beads can be used. Typically, a ferrite bead is formed from a material have a permeability controlled by the composition of different oxides, for example, a ferrite oxide, sometimes with nickel and zinc added. The ferrite beads can sometimes be formed as ferrite sleeves with two half parts that are added onto to signal line or a solder overcoat on a signal trace. Typically, the longer the bead, the better the RF suppression. The bead equivalence circuit can be a series resistor and inductor.

An example of a preamplifier **60** is shown in FIG. 4 and includes a preamplifier chip **60a** and the RF filters (FB-L1 and FB-L2) applied to the left channel and right channel inputs Lc-IN and Rc-IN of the preamplifier circuit to prevent RF pick-up and rectification. Other RF filters (FB_L3 and FB_L4) are applied to the feedback circuit **80** as serial filters with previous connected serial resistors **82.** The feedback circuit can include respective left channel and right channel feedback circuits. RF filters could also be applied to the power rail **84,** for example, the illustrated filters FB_L5 or FB_L6. The power rail can also include respective left and right channel power rails.

The preamplifier circuit **60** shown in FIG. 4 is a typical type of preamplifier such as the *µ*PC4570 sold by NEC Electronics Corporation as a bipolar analog integrated circuit or one nonlimiting example. This circuit is an ultra low-noise wideband device having a high-slew rate, with dual operation and basic inputs and appropriate feedback. The preamplifier can be formed as an 8-pin plastic dual inline package (DIP) or SOP. In FIG. 4, the circuit is illustrated as a 9-pin plastic slim, single inline package (SIP). It is typically soldered and mounted as a surface mount device, for example as shown in the fragmentary drawing of FIG. 2, and is typically mounted through an infrared ray reflow, vapor face soldering, wave soldering or partial heating method.

As illustrated, the RF filters **70** can be applied to three main circuit areas, including the left channel input (Lc-IN) and right channel input (Rc-IN) and operative with the capacitors (Cbp-1 and Cbp-2) that are part of that circuit. The serial resistors **82** in the feedback circuit **80** are operative with the capacitors (Cbp_3 and Cbp_4) and RF filters (FB_L3 and FB_L4). The power rail **84** can include the RF filters operative with capacitors Cbp_5 and Cbp_6.

An example of a power amplifier circuit **64** that could be used in a personal computer speaker system such as shown in FIG. 1 is illustrated in the schematic circuit diagram of FIG. 5. This one nonlimiting example is formed as a two-channel, 12 watt audio frequency power amplifier chip **64a,** sold under the designation LA4700N by Sanyo Electric Company, Limited. This power amplifier can be a single inline package (SIP) or other design and includes various internal switch functions, including a standby switch function, pop noise suppressor, thermal shutdown, over voltage/surge protector, output pin-to-ground short protector, output pin-to-Vcc short protector, and load short protector, all built within the circuit. The circuit can have low pop noise during power ON/OFF operation and excellent oscillation stability. Different inputs and pin terminals can include the left channel input and right channel input at respective pins 8 and 11. A pop noise suppressor circuit could be operatively connected to those pins. A ground is connected to pin **10.** Non-inverting and inverting inputs could be operative at pins **6** and **7,** and a left channel power ground at pin **2.** Respective inverting and non-inverting outputs are connected to respective pins **3** and **1,** which also are connected to respective inverting and non-inverting amplifier circuits.

The left channel and right channel Vcc are connected to respective pins **4** and **15** and to a protector circuit. A second set of right channel non-inverting and inverting outputs are connected to respective pins **18** and **16.** The non-inverting and inverting amplifiers for the right channel with connections to the non-inverting NF and inverting NF are at respective pins **12** and **13.**

As illustrated in FIG. 5, the left channel and right channel inputs (LcIN and RcIN) each include RF filters **70** of the present invention, which could be formed as ferrite beads, serial inductors or capacitors as described before. The filters **70** are designed as FB1 and FB2. It is evident that the feedback RF filters FB-L3 and FB-L4 at the preamplifier circuit **60** are operative with the RF filters FB1 and FB2. These are positioned in the left channel input LcIN and right channel input RcIN of the power amplifier circuit **64** and operative through any transition buffering and filtering circuitry **62.** The power amplifier circuit, of course, includes a switch circuit **90** connected to pin **9** and associated resistor and capacitor circuits **92-95.** A main switch **98** is operative for power control.

## Claims

1. A speaker system (17) having improved immunity to RF electromagnetic interference produced from mobile wireless communications devices (18) comprising:
a speaker housing (22, 72);
an audio transducer (32) carried by the speaker housing;
a circuit board (24) carried by the housing and having audio circuitry mounted thereon and operative with the audio transducer, said audio circuitry including a power amplifier (36, 64) having left and right channel inputs for receiving and amplifying an audio signal to the audio transducer, and
a ferrite bead, inductor or shunt capacitor serially connected into each of said left and right channel inputs of the power amplifier,
wherein said audio circuitry further comprises an operational amplifier (60a) operative as a preamplifier (34, 60) with said power amplifier for receiving and amplifying audio signals to the power amplifier, said operational amplifier including a left and right channel voltage rail (84), left and right channel inputs (76) and a left and right channel feedback line (80), and, as RF filter (70), a ferrite bead, inductor or shunt capacitor serially connected into said left and right channel feedback line.

2. A speaker system (17) according to claim 1 and further comprising a filter mounted at the audio transducer (32) for reducing RF electromagnetic interference generated from a mobile wireless communications device (18) to said audio transducer.

3. A speaker system (17) according to claim 2 wherein said filter comprises an RF shield surrounding said audio transducer.

4. A speaker system (17) according to claim 2 wherein said audio transducer includes audio input lines and said filter comprises a ferrite bead, serial inductor or shunt capacitor connected into said audio input lines.

5. A speaker system (17) according to claim 1 wherein said audio transducer (32) comprises a receiver speaker mounted on said housing.

6. A speaker system (17) according to claim 1 and further comprising a power circuit mounted on the circuit board (24) and operative with the power amplifier (36, 64), and an RF shield (50) surrounding and isolating said power circuit from RF electromagnetic interference produced from a mobile wireless communications device (18).

7. A method of making a speaker system (17) that has improved immunity to RF electromagnetic interference produced from a mobile wireless communications device (18) which comprises:
providing a speaker housing (22, 72), an audio transducer (32) carried by the speaker housing, a circuit board (24) carried by the housing and having audio circuitry mounted thereon and operative with the audio transducer, a power amplifier (36, 64) on the circuit board and having left and right channel inputs for receiving an audio signal and amplifying the audio signal to the audio transducer, and
connecting a ferrite bead, inductor or shunt capacitor serially into each of said left and right channel inputs of the power amplifier, wherein the audio circuitry further comprises an operational amplifier (60a) as a preamplifier (34, 60) for receiving and amplifying audio signals to the power amplifier, said operational amplifier including a left and right channel voltage rail (84), left and right channel inputs (76) and a left and right channel feedback line (80), and serially connecting, as RF filter (70), a ferrite bead, inductor or shunt capacitor into the left and right channel feedback line of said preamplifier.

8. A method according to claim 7 which further comprises surrounding the power amplifier (36, 64) with an RF shield (50) for isolating the power amplifier from RF electromagnetic interference produced by a mobile wireless communications device (18).

9. A method according to claim 8 which further comprises forming the RF shield (50) as a metallic housing secured to said circuit board (24) and surrounding said power amplifier (36, 64).

## Patentansprüche

1. Lautsprechersystem (17), das eine verbesserte Störunempfindlichkeit gegen HF-elektromagnetische Beeinflussung aufweist, die von mobilen drahtlosen Kommunikationseinrichtungen (18) erzeugt werden, Folgendes umfassend:
ein Lautsprechergehäuse (22, 72);
einen Schallwandler (32), der durch das Lautsprechergehäuse getragen wird;
eine Leiterplatte (24), die durch das Gehäuse getragen wird und eine darauf montierte Audioschaltung aufweist und mit dem Schallwandler betriebsfähig ist, wobei die Audioschaltung einen Leistungsverstärker (36, 64) beinhaltet, der einen Eingang des linken und des rechten Kanals zum Empfangen und zum Verstärken eines Audiosignals an den Schallwandler aufweist, und
eine Ferritperle, einen Induktor oder einen Parallelkondensator, die/der in jeweils dem Eingang des linken und des rechten Kanals des Leistungsverstärkers seriell verbunden ist,
wobei die Audioschaltung ferner einen Operationsverstärker (60a) umfasst, der als ein Vorverstärker (34, 60) mit dem Leistungsverstärker zum Empfangen und Verstärken von Audiosignalen an dem Leistungsverstärker betriebsfähig ist, wobei der Operationsverstärker eine Spannungsschiene des linken und des rechten Kanals (84), einen Eingang des linken und des rechten Kanals (76) und eine Rückkopplungsleitung des linken und des rechten Kanals (80) und, als HF-Filter (70), eine Ferritperle, den Induktor oder den Parallelkondensator beinhaltet, die/der in der Rückkopplungsleitung des linken und des rechten Kanals seriell verbunden ist.

2. Lautsprechersystem (17) nach Anspruch 1 und ferner umfassend einen Filter, der an dem Schallwandler (32) zum Reduzieren von HF-elektromagnetischer Beeinflussung montiert ist, die von einer mobilen drahtlosen Kommunikationseinrichtung (18) an dem Schallwandler erzeugt werden.

3. Lautsprechersystem (17) nach Anspruch 2, wobei der Filter eine HF-Abschirmung umfasst, die den Schallwandler umgibt.

4. Lautsprechersystem (17) nach Anspruch 2, wobei der Schallwandler Audioeingangsleitungen beinhaltet und der Filter eine Ferritperle, den seriellen Induktor oder den Parallelkondensator umfasst, die/der in den Audioeingangsleitungen verbunden ist.

5. Lautsprechersystem (17) nach Anspruch 1, wobei der Schallwandler (32) einen Empfängerlautsprecher umfasst, der an dem Gehäuse montiert ist.

6. Lautsprechersystem (17) nach Anspruch 1 und ferner umfassend einen Leistungskreis, der auf der Leiterplatte (24) montiert und mit dem Leistungsverstärker (36, 64) betriebsfähig ist, und eine HF-Abschirmung (50), die den Leistungskreis umgibt und von HF-elektromagnetischer Beeinflussung isoliert, die von einer mobilen drahtlosen Kommunikationseinrichtung (18) erzeugt wird.

7. Verfahren zum Herstellen eines Lautsprechersystems (17), das eine verbesserte Störunempfindlichkeit gegen HF-elektromagnetische Beeinflussung aufweist, die von einer mobilen drahtlosen Kommunikationseinrichtung (18) erzeugt wird, Folgendes umfassend:
Bereitstellen eines Lautsprechergehäuses (22, 72), eines durch das Lautsprechergehäuse getragenen Schallwandlers (32), einer durch das Gehäuse getragenen Leiterplatte (24), die eine darauf montierte Audioschaltung aufweist und mit dem Schallwandler betriebsfähig ist, eines Leistungsverstärkers (36, 64) auf der Leiterplatte, der den Eingang des linken und des rechten Kanals zum Empfangen eines Audiosignals und Verstärken des Audiosignals an dem Schallwandler aufweist, und serielles Verbinden einer Ferritperle, des Induktors oder des Parallelkondensators in jeweils dem Eingang des linken und des rechten Kanals des Leistungsverstärkers, wobei die Audioschaltung ferner einen Operationsverstärker (60a) als einen Vorverstärker (34, 60) zum Empfangen und Verstärken von Audiosignalen an dem Leistungsverstärker umfasst, wobei der Operationsverstärker eine Spannungsschiene des linken und des rechten Kanals (84), einen Eingang des linken und des rechten Kanals (76) und eine Rückkopplungsleitung des linken und des rechten Kanals (80) beinhaltet, und das serielle Verbinden, als HF-Filter (70), einer Ferritperle, des Induktors oder des Parallelkondensators in die Rückkopplungsleitung des linken und des rechten Kanals des Vorverstärkers.

8. Verfahren nach Anspruch 7, das ferner das Umgeben des Leistungsverstärkers (36, 64) mit einer HF-Abschirmung (50) zum Isolieren des Leistungsverstärkers gegen HF-elektromagnetische Beeinflussung umfasst, die durch eine mobile drahtlose Kommunikationseinrichtung (18) erzeugt wird.

9. Verfahren nach Anspruch 8, das ferner das Ausbilden der HF-Abschirmung (50) als ein Metallgehäuse umfasst, das an der Leiterplatte (24) befestigt ist und den Leistungsverstärker (36, 64) umgibt.

## Revendications

1. Système de haut-parleur (17) présentant une immunité améliorée aux interférences électromagnétiques RF produites à partir de dispositifs de communication sans fil mobiles (18) comprenant :
un boîtier de haut-parleur (22, 72) ;
un transducteur audio (32) porté par le boîtier de haut-parleur ;
une carte de circuit imprimé (24) portée par le boîtier et sur laquelle est montée une circuiterie audio et fonctionnant avec le transducteur audio, ladite circuiterie audio comportant un amplificateur de puissance (36, 64) ayant des entrées de canaux gauche et droit pour recevoir et amplifier un signal audio vers le transducteur audio, et une perle isolante de ferrite, un inducteur ou un condensateur shunt connecté en série à chacune desdites entrées de canaux gauche et droit de l'amplificateur de puissance,
ladite circuiterie audio comprenant en outre un amplificateur fonctionnel (60a) fonctionnant comme préamplificateur (34, 60) avec ledit amplificateur de puissance destiné à recevoir et amplifier des signaux audio destinés à l'amplificateur de puissance, ledit amplificateur fonctionnel comportant un rail de tension de canaux gauche et droit (84), des entrées de canaux gauche et droit (76) et une ligne de rétroaction de canaux gauche et droit (80), et, en tant que filtre RF (70), une perle isolante de ferrite, un inducteur ou un condensateur shunt connecté en série à ladite ligne de rétroaction des canaux gauche et droit.

2. Système de haut-parleur (17) selon la revendication 1 et comprenant en outre un filtre monté au niveau du transducteur audio (32) pour réduire les interférences électromagnétiques RF générées par un dispositif de communication sans fil mobile (18) vers ledit transducteur audio.

3. Système de haut-parleur (17) selon la revendication 2, ledit filtre comprenant un écran RF entourant ledit transducteur audio.

4. Système de haut-parleur (17) selon la revendication 2, ledit transducteur audio comportant des lignes d'entrée audio et ledit filtre comprenant une perle isolante de ferrite, un inducteur en série ou un condensateur shunt connecté auxdites lignes d'entrée audio.

5. Système de haut-parleur (17) selon la revendication 1, ledit transducteur audio (32) comprenant un haut-parleur récepteur monté sur ledit boîtier.

6. Système de haut-parleur (17) selon la revendication 1 et comprenant en outre un circuit de puissance monté sur la carte de circuit imprimé (24) et fonctionnant avec l'amplificateur de puissance (36, 64), et un écran RF (50) entourant et isolant ledit circuit de puissance des interférences électromagnétiques RF produites à partir d'un dispositif de communication sans fil mobile (18).

7. Procédé de fabrication d'un système de haut-parleur (17) qui présente une immunité améliorée aux interférences électromagnétiques RF produites à partir d'un dispositif de communication sans fil mobile (18) qui comprend :
la fourniture d'un boîtier de haut-parleur (22, 72), d'un transducteur audio (32) porté par le boîtier de haut-parleur, d'une carte de circuit imprimé (24) portée par le boîtier et sur laquelle une circuiterie audio est montée et fonctionnant avec le transducteur audio, d'un amplificateur de puissance (36, 64) sur la carte de circuit imprimé et ayant des entrées de canaux gauche et droit pour recevoir un signal audio et amplifier le signal audio vers le transducteur audio, et
la connexion d'une perle isolante de ferrite, d'un inducteur ou d'un condensateur shunt en série à chacune desdites entrées de canaux gauche et droite de l'amplificateur de puissance, la circuiterie audio comprenant en outre un amplificateur fonctionnel (60a) en tant que préamplificateur (34, 60) destiné à recevoir et amplifier des signaux audio destinés à l'amplificateur de puissance, ledit amplificateur fonctionnel comportant un rail de tension de canaux gauche et droit (84), des entrées de canaux gauche et droit (76) et une ligne de rétroaction de canaux gauche et droit (80), et la connexion en série, comme filtre RF (70), d'une perle isolante de ferrite, d'un inducteur ou d'un condensateur shunt à la ligne de rétroaction des canaux gauche et droit dudit préamplificateur.

8. Procédé selon la revendication 7, qui comprend en outre le fait d'entourer l'amplificateur de puissance (36, 64) d'un écran RF (50) pour isoler l'amplificateur de puissance des interférences électromagnétiques RF produites par un dispositif de communication sans fil mobile (18).

9. Procédé selon la revendication 8, qui comprend en outre la formation de l'écran RF (50) sous la forme d'un boîtier métallique fixé à ladite carte de circuit imprimé (24) et entourant ledit amplificateur de puissance (36, 64).
